# EUROPÄISCHE PATENTSCHRIFT

(11) **EP 4 340 553 B1**
(45) Veröffentlichungstag und Bekanntmachung des Hinweises auf die Patenterteilung: **26.02.2025**
(21) Anmeldenummer: 23183264.3
(22) Anmeldetag: 04.07.2023
(51) Int. Cl.: H05K 3/34

(54) **ELEKTRONIKMODUL MIT INTEGRIERTER LEITERPLATTENAUFNAHME ZUR KONTAKTIERUNG ZUMINDEST EINES DRAHTES MIT EINER IN DER LEITERPLATTENAUFNAHME ANORDENBAREN LEITERPLATTE SOWIE ZUGEHÖRIGES VERFAHREN**
ELECTRONIC MODULE WITH INTEGRATED CIRCUIT BOARD HOLDER FOR CONTACTING AT LEAST ONE WIRE WITH A CIRCUIT BOARD THAT CAN BE ARRANGED IN THE CIRCUIT BOARD HOLDER, AND ASSOCIATED METHOD
MODULE ÉLECTRONIQUE DOTÉ D'UN LOGEMENT DE CARTE DE CIRCUIT IMPRIMÉ INTÉGRÉ DESTINÉ À LA MISE EN CONTACT D'AU MOINS UN FIL AVEC UNE CARTE DE CIRCUIT IMPRIMÉ POUVANT ÊTRE DISPOSÉE DANS LE LOGEMENT DE CARTE DE CIRCUIT IMPRIMÉ ET PROCÉDÉ ASSOCIÉ

(30) Priorität: 09.09.2022 DE 102022122933
(43) Veröffentlichungstag der Anmeldung: 20.03.2024
(73) Patentinhaber: Marquardt GmbH, 78604 Rietheim-Weilheim (DE)
(72) Erfinder: Zimmer, Andreas, 78655 Dunningen (DE); Weinöhl, Markus, 78573 Wurmlingen (DE)
(74) Vertreter: Staeger & Sperling Partnerschaftsgesellschaft mbB

(56) Entgegenhaltungen:
- WO-A1-03/009427
- DE-U1- 202013 010 951
- US-A1- 2019 357 356

## Beschreibung

Die Erfindung betrifft ein Elektronikmodul mit integrierter Leiterplattenaufnahme zur Kontaktierung zumindest eines Drahtes mit einer in der Leiterplattenaufnahme anordenbaren Leiterplatte sowie ein zugehöriges Verfahren zur Kontaktierung zumindest eines Drahtes mit einer in der Leiterplattenaufnahme des Elektronikmoduls anordenbaren Leiterplatte.

Grundsätzlich sind aus dem Stand der Technik bereits eine Vielzahl von Vorrichtungen und Verfahren zur Kontaktierung von Bauteilen oder Drähten mit Leiterplatten bzw. den auf den Leiterplatten dafür vorgesehenen Kontakten bekannt.

Neben dem allgemein bekannten Verlöten von Bauteilen mit den Kontakten der Leiterplatte, sind beispielsweise aus der DE 10 2016 212 631 A1 Anschlusselemente zum Auflöten bzw. Verlöten mit Leiterplatten bekannt, bei welchen ein Bauteil oder ein Draht anschließend über das Anschlusselement mit der Leiterplatte verbindbar ist. Dabei ist jedoch nachteilhaft, dass der Draht erst an dem dadurch gebildeten Elektronikmodul angeordnet werden kann, wenn die Leiterplatte zuvor mit den Anschlusselementen bestückt und diese mit den Kontakten der Leiterplatte verlötet wurden.

Weiter ist beispielsweise aus der DE 20 2017 105 830 U1 ein System bekannt, durch welches Drähte im Sinne von Litzen durch ein Bügellötverfahren auf eine flexible Leiterplatte aufgelötet werden. Auch durch dieses System wird die Reihenfolge fest vorgegeben, da die Leiterplatte zunächst in einem Werkzeug angeordnet werden muss, bevor die Drähte platziert werden können, um die Drähte anschließend durch Bügellöten mit den Kontakten der Leiterplatte zu verbinden.

Speziell auf Spulen bzw. zu Spulen gewickelte Drähte bezogen, lehrt zudem die DE 20 2013 010 951 U1 einen Leiterplattenverbund, bei welchen Kontaktelemente in die Leiterplatte eingesteckt und mit dieser dauerhaft kontaktiert werden müssen, bevor die Spulendrähte wiederum in die Kontaktelemente geführt werden können. Auch hier wird entsprechend die Montagereihenfolge fest bestimmt, zumal neben den Kontaktflächen der Leiterplatten und den Drähten zusätzliche Kontaktelemente und deren Montage notwendig sind, um die Kontaktierung zu ermöglichen.

DE 101 34 562 A1 offenbart ein System zur elektrischen Kontaktierung und mechanischen Befestigung von Leiterplatten aufweisend: ein Schneidklemmelement zur Anbringung an der Unterseite einer Leiterplatte, ein Befestigungselement an der Leiterplatte, einen Träger, bezüglich dem ein Leitungsdraht derart fixiert ist, dass bei der mechanischen Befestigung der Leiterplatte mit dem Träger mittels des leiterplattenseitigen Befestigungselements gleichzeitig der Leitungsdraht durch das Schneidklemmelement an der Unterseite der Leiterplatte direkt kontaktierbar ist.

Der Erfindung liegt deshalb die Aufgabe zugrunde, die vorgenannten Nachteile zu überwinden und ein Elektronikmodul bereitzustellen, durch welches Drähte und insbesondere Spulendrähte in einfacher und kosteneffizienter Weise mit einer Leiterplatte bzw. den dafür vorgesehenen Kontaktflächen der Leiterplatte kontaktiert werden können.

Diese Aufgabe wird durch die Merkmalskombination gemäß Patentanspruch 1 gelöst.

Erfindungsgemäß wird daher ein Elektronikmodul mit integrierter Leiterplattenaufnahme zur Kontaktierung zumindest eines Drahtes mit einer in der Leiterplattenaufnahme anordenbaren und beispielsweise in die Leiterplattenaufnahme einschiebbaren Leiterplatte vorgeschlagen. Die Leiterplattenaufnahme weist zumindest ein Führungselement auf, welches ausgebildet ist, die in der Leiterplattenaufnahme anordenbare Leiterplatte in eine vorbestimmte Endposition zu führen und insbesondere auch in der Endposition zu halten. Dabei ist vorgesehen, dass die Leiterplatte in der Endposition in einer vorbestimmten Ebene angeordnet ist und sich auf der Leiterplatte vorgesehene Kontaktflächen in einer vorbestimmten Montageposition befinden. Zudem weist die Leiterplattenaufnahme für jeden mit der Leiterplatte zu kontaktierenden Draht zwei Drahtaufnahmen d.h. je Draht ein Paar von Drahtaufnahmen auf, wobei die zwei Drahtaufnahmen bzw. die Drahtaufnahmen des Paares einander an der Leiterplattenaufnahme gegenüberliegen und ausgebildet sind, einen zwischen den zwei Drahtaufnahmen geradlinig und frei verlaufenden und vorzugsweise mit einer vorbestimmten Vorspannung gespannten Draht aufzunehmen sowie weiter vorzugsweise zu fixieren. Dabei wird unter frei verlaufend insbesondere verstanden, dass der Draht, solange er noch nicht mit der Kontaktfläche kontaktiert ist, zwischen zugehörigen den Drahtaufnahmen verlaufend keine anderen Elemente und insbesondere nicht eine bereits in der Leiterplattenaufnahme angeordnete Leiterplatte berührt. Erfindungsgemäß ist zudem vorgesehen, dass die zwei Drahtaufnahmen, d.h. das Paar von Drahtaufnahmen, ferner ausgebildet sind, zumindest einen Drahtabschnitt des geradlinig zwischen den zwei Drahtaufnahmen verlaufenden Drahtes in einem vorbestimmten Abstand zu der Montageposition bzw. der zugehörigen Kontaktfläche einer bereits in der Leiterplattenaufnahme angeordneten Leiterplatte und weiter insbesondere parallel zu der Kontaktfläche bzw. der Ebene verlaufend zu halten, sodass der Draht aus dieser vorbekannten Position mit dem Drahtabschnitt von einem Montagewerkzeug gegen die Kontaktfläche in der vorbekannten Montageposition pressbar und mit der Kontaktfläche verbindbar ist.

Bei dem Elektronikmodul bzw. der Leiterplattenaufnahme handelt es sich insbesondere nicht um ein Werkzeug oder eine Schablone, welche nach der Kontaktierung entfernt werden, sondern vorzugsweise um einen integralen Bestandteil eines herzustellenden und das Elektronikmodul entsprechend aufweisenden Gegenstands.

Für das zumindest eine Führungselement ist vorzugsweise vorgesehen, dass dieses angeordnet und ausgebildet ist, die Leiterplatte unabhängig von dem zumindest einem Draht in die Endposition zu führen, sodass die Leiterplatte also von außen in die Führungsvorrichtung und in der Führungsvorrichtung in die Endposition geführt werden kann, unabhängig davon, ob die Drahtaufnahmen leer sind oder bereits ein Draht in ihnen angeordnet ist.

Entsprechend gilt vorzugsweise für die Drahtaufnahmen, dass der Draht in den Drahtaufnahmen unabhängig von der Leiterplatte angeordnet werden kann, sodass der zumindest eine Draht vor oder nach der Leiterplattenmontage d.h. vor oder nach dem Anordnen der Leiterplatte in der Leiterplattenaufnahme in bzw. an dieser angeordnet werden kann.

Obwohl die Leiterplatte und der zumindest eine Draht jeweils als separat von dem Elektronikmodul betrachtet werden können, können die Leiterplatte und/oder der zumindest eine Draht auch als eine zu dem Elektronikmodul gehörende Komponente gesehen werden.

Vorzugsweise ist vorgesehen, dass die Leiterplattenaufnahme vier Drahtaufnahmen bzw. zwei Paare von Drahtaufnahmen aufweist, sodass zwei Drähte mit jeweils einer auf der Leiterplatte dafür vorgesehenen Kontaktfläche kontaktierbar sind.

Die zwei Drähte können dabei insbesondere auch als die zwei einander gegenüberliegenden und somit miteinander verbundenen Drahtenden eines beispielsweise zu einer Spule gewickelten Drahtes verstanden werden. Entsprechend können jeweils zwei Drähte miteinander verbunden sein.

Weiter ist das gesamte Elektronikmodul vorzugsweise einteilig, insbesondere einstückig und weiter vorzugsweise aus Kunststoff gebildet. Beispielsweise kann das Elektronikmodul im Kunststoffspritzgussverfahren hergestellt werden.

Eine vorteilhafte Weiterbildung sieht vor, dass die Leiterplattenaufnahme zwei einander gegenüberliegende Führungsschienen als Führungselemente aufweist, zwischen welche die Leiterplatte in der Ebene einschiebbar ist. Dabei können die Führungsschienen an einer Seite der Ebene miteinander verbunden und an der gegenüberliegenden zweiten Seite der Ebene voneinander getrennt sein, sodass die Leiterplatte von der zweiten Seite her vollflächig zugänglich bleibt.

Vorzugsweise ist dabei vorgesehen, dass jeweils eine Drahtaufnahme der zwei Drahtaufnahmen bzw. des Paares von Drahtaufnahmen jeweils einer Führungsschiene der zwei Führungsschienen zugeordnet ist, sodass der Draht von einer ersten Führungsschiene zu einer zweiten Führungsschiene verlaufend in den Drahtaufnahmen angeordnet werden kann.

Alternativ zu den zwei einander gegenüberliegenden Führungsschienen, kann alternativ vorgesehen sein, dass die Leiterplattenaufnahme zumindest einen sich orthogonal zu der Ebene erstreckenden Führungszapfen als Führungselement aufweist, entlang welchem die Leiterplatte in die Ebene schiebbar ist.

Dabei können auch zwei oder mehrere zueinander versetzt angeordnete Führungszapfen vorgesehen sein. Insbesondere, wenn nur ein Führungszapfen vorgesehen ist, kann dieser asymmetrisch oder rechteckig ausgebildet sein oder aber mit weiteren Führungselementen zusammenwirken, um die Anordnung der Leiterplatte in der Endposition mit einer vorbestimmten Orientierung zu gewährleisten, in welcher sich die zumindest eine Kontaktfläche in ihrer jeweiligen Montageposition befindet.

Bezüglich der Leiterplatte ist bei der Verwendung von Führungszapfen festzustellen, dass diese zu dem zumindest einen Führungszapfen korrespondierende Ausnehmungen oder Durchbrüche aufweist.

Weiter sieht das Elektronikmodul bei einer Variante vor, dass die Leiterplattenaufnahme zumindest einen sich orthogonal zu der Ebene erstreckenden und die Endposition bestimmenden Endanschlag aufweist, gegen welchen die Leiterplatte schiebbar ist. Sind Führungsschienen vorgesehen, kann der Endanschlag eine orthogonal zu der Ebene verlaufende Anschlagfläche bereitstellen. Im Falle von Führungszapfen stellt der Endanschlag vorzugsweise eine parallel zu der Ebene verlaufende Anschlagfläche bereit.

Um den Draht bzw. die Drähte in einfacherweise in ihre vorbestimmte Position bringen zu können sieht eine Weiterbildung zudem vorzugsweise vor, dass zumindest ein Teil der Drahtaufnahmen und insbesondere alle Drahtaufnahmen jeweils als sich verjüngende und dadurch insbesondere als Trichter wirkende Nuten ausgebildet sind, in welche der jeweilige Draht zur Zentrierung und Positionierung des Drahtes von einer geöffneten Seite der Nuten einführbar ist. Entsprechend kann die Nut einen v-förmigen Querschnitt aufweisen.

Insbesondere in dem verjüngten Endabschnitt der Nut, können zudem Fixiermittel, wie in die Nut hineinstehende Klemmschneiden oder Rasthaken vorgesehen sein, welche einen in die Nut eingeführten und bis in den Endabschnitt gebrachten Draht dort fixieren. Solche Fixiermittel können weiter auch nur bei einer Drahtaufnahme eines Paares und vorzugsweise an der näher an einem freien Drahtende des Drahtes angeordneten Drahtaufnahme vorgesehen sein.

Neben einseitig offenen Nuten, welche wie beschrieben verjüngt sein können, sind ferner auch als Durchbruch ausgebildete Drahtaufnahmen möglich, welche jedoch den Nachteil haben, dass sie im Gegensatz zu einer Nut eine geschlossene Kontur aufweisen, sodass der Draht in die jeweiligen Durchbrüche eingefädelt werden muss. Abhängig von dem strukturellen Aufbau des Elektronikmoduls kann dies jedoch erforderlich oder sinnvoll sein.

Dabei kann die Ausbildung der Drahtaufnahmen gemischt werden. Beispielsweise kann eine erste Drahtaufnahme eines Paares als Nut und eine zweite Drahtaufnahme des Paares als Durchbruch ausgebildet sein.

Ein Teil der Drahtaufnahmen kann und insbesondere alle Drahtaufnahmen können sich von einer von der Ebene abgewandten Seite der Leiterplattenaufnahme bis an die Ebene erstrecken ohne die Ebene zu schneiden, sodass der zwischen den Drahtaufnahmen verlaufende Draht an einer ersten Seite der Ebene angeordnet bzw. anordenbar ist.

Alternativ kann sich ein Teil der Drahtaufnahmen und insbesondere können alle Drahtaufnahmen von einer von der Ebene abgewandten Seite der Leiterplattenaufnahme bis über die Ebene hinaus erstrecken und die Ebene schneiden, sodass der zwischen den Drahtaufnahmen verlaufende Draht an einer zweiten Seite der Ebene angeordnet ist, welche bezogen auf die Ebene der ersten Seite gegenüberliegt.

Weiter kann auch vorgesehen sein, dass sich ein erster Teil der Drahtaufnahmen bis an die Ebene erstreckt ohne die Ebene zu schneiden und ein zweiter Teil der Drahtaufnahmen sich über die Ebene hinaus erstreckt und die Ebene schneiden. Der erste Teil der Drahtaufnahmen ist entsprechend auf der ersten Seite und der zweite Teil der Drahtaufnahmen auf der zweiten Seite angeordnet, wobei die Drahtaufnahmen eines Paares jeweils derart angeordnet und ausgebildet sind, dass sich der durch sie verlaufende Draht parallel der Ebene und in dem vorbestimmten Abstand zu der Montageposition erstreckt.

Auch kann sich ein erster Teil der Drahtaufnahmen von einer ersten Seite bis an die Ebene erstrecken ohne die Ebene zu schneiden und ein zweiter Teil der Drahtaufnahmen sich von einer zweiten Seite, welche der ersten Seite bezogen auf die Ebene gegenüberliegt, bis an die Ebene erstrecken ohne die Ebene zu schneiden, sodass Drähte auf beiden Seiten der Ebene bzw. der Leiterplatte anordenbar und mit der Leiterplatte verbindbar sind.

Um das freie Ende eines Drahtes an dem Elektronikmodul bzw. an der Leiterplattenaufnahme fixieren zu können, kann die Leiterplattenaufnahme insbesondere je mit der Leiterplatte zu kontaktierenden Draht ein insbesondere als Wickelzapfen ausgebildetes Fixierelement aufweisen, an welchem ein insbesondere freies Ende des geradlinig zwischen den zwei Drahtaufnahmen verlaufenden Drahtes fixierbar ist. Der Draht kann entsprechend mit seinem freien Ende mehrfach um den Wickelzapfen gewunden und dadurch insbesondere mit der vorbestimmten Vorspannung zwischen den Drahtaufnahmen gespannt und fixiert werden. Weiter kann das Fixierelement auch beispielsweise als Klemmmechanismus ausgebildet sein, durch welchen der Draht zwischen den zugehörigen Drahtaufnahmen gespannt und an dem Fixierelement festgeklemmt werden kann.

Der vorbestimmte Abstand des Drahtes zu der Montageposition ist vorzugsweise kleiner 5 mm, insbesondere kleiner 1 mm und weiter insbesondere gleich oder kleiner 0,5 mm. Dabei wird der Abstand insbesondere so gewählt, dass der Draht insbesondere gespannt gegen die zugehörige Kontaktfläche gepresst werden kann. Wird der Draht bereits zuvor z.b. durch die Vorspannung gespannt zwischen den zugehörigen Drahtaufnahmen angeordnet, wird der Draht entsprechend beim Pressen gegen die Kontaktfläche gedehnt bzw. mit einer höheren Spannung beaufschlagt. Daher kann auch vorgesehen sein, dass der Draht bzw. der Verlauf des Drahtes zwischen den Drahtaufnahmen zwar im Wesentlichen geradlinig aber zumindest vor dem Verbinden mit der Kontaktfläche noch nicht entsprechend seiner maximalen Belastbarkeit gespannt ist, sodass ein Auslenken aus diesem Verlauf gegen die Kontaktfläche möglich wird.

Vorzugsweise weist das Elektronikmodul ferner einen Spulenwicklungskörper auf, um welchem eine aus dem zumindest einem Draht gewickelte Spule anordenbar oder wickelbar ist.

Wie zuvor erwähnt kann das Elektronikmodul einstückig sein, sodass der Spulenwicklungskörper integral mit der Leiterplattenaufnahme ausgebildet sein kann.

Es ist ferner darauf hinzuweisen, dass die Kontaktflächen der Leiterplatte nicht an einer gemeinsamen Seite der Leiterplatte vorgesehen sein müssen. Beispielsweise kann zumindest eine erste Kontaktfläche auf einer ersten Seite angeordnet sein und zumindest eine zweite Kontaktfläche auf einer gegenüberliegenden Seite.

Bezogen auf die vorbestimmte Ebene, können die zu der zumindest einen ersten Kontaktflächen zugehörigen Drähte entsprechend auf einer ersten Seite der Ebene und die zu der zumindest einen zweiten Kontaktfläche zugehörigen Drähte auf einer zweiten Seite der Ebene verlaufend angeordnet werden. Dabei sind die den Drähten zugeordneten Drahtaufnahmen entsprechend ausgebildet und angeordnet den jeweiligen Draht auf der ersten Seite der Ebene oder auf der zweiten Seite der Ebene in dem vorbestimmten Abstand zu der jeweils zugehörigen Kontaktfläche zu halten.

Neben dem Elektronikmodul an sich betrifft ein weiterer Aspekt der Erfindung ein Verfahren zur Kontaktierung zumindest eines Drahtes mit einer in der Leiterplattenaufnahme des erfindungsgemäßen Elektronikmoduls anordenbaren Leiterplatte. Das Verfahren umfasst hierbei die Schritte
a. Anordnen der Leiterplatte in der Leiterplattenaufnahme, sodass sich die je Draht auf der Leiterplatte vorgesehene Kontaktfläche in der Montageposition befindet;
b. Anordnen des zumindest einen Drahts in den jeweiligen bzw. zugehörigen Drahtaufnahmen, sodass der Draht geradlinig zwischen den zwei Drahtaufnahmen verläuft und den vorbestimmten Abstand zu der Montageposition aufweist;
c. Kontaktieren des zumindest einen Drahts mit der jeweiligen Kontaktfläche durch Pressen des Drahtes gegen die Kontaktfläche und elektrische Kontaktierung mit der Kontaktfläche, insbesondere durch Löten und weiter insbesondere im Bügellötverfahren.

Dabei ist vorgesehen, dass die Schritte sowohl in der Reihenfolge a, b, c als auch in der Reihenfolge b, a, c durchführbar sind bzw. durchgeführt werden können.

Für das Bügellötverfahren wird insbesondere ein als Stempel ausgebildetes Montagewerkzeug verwendet, welches orthogonal oder parallel zu der Ebene an die Leiterplatte bewegbar und jeweils zumindest einen Draht gegen die zu dem jeweiligen Draht gehörende Kontaktfläche pressend an die Kontaktfläche führbar ist.

Alternativ zu einem Kontaktieren durch Löten oder Bügellöten kann der Draht auch beisspielsweise durch Bonden oder Laserlöten mit der Konraktfläche verbunden werden, wobei hierfür gegebenenfalls weiterhin ein Stempel notwendig ist, welcher den Draht gegen die Kontaktfläche presst, jedoch dabei nicht aktiv zur dauerhaften Kontaktierung des Drahtes mit der Kontaktfläche beiträgt.

Die vorstehend offenbarten Merkmale sind beliebig kombinierbar, soweit dies technisch möglich ist und diese nicht im Widerspruch zueinander stehen.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: ein Elektronikmodul mit daran angeordneter Leiterplatte und Drähten vor dem Kontaktieren in Seitenansicht;
- Fig. 2: das Elektronikmodul mit daran angeordneter Leiterplatte und Drähten nach dem Kontaktieren in Seitenansicht;
- Fig. 3: das Elektronikmodul ohne daran angeordneter Leiterplatte und Drähten in Seitenansicht;
- Fig. 4: das Elektronikmodul mit daran angeordneter Leiterplatte und Drähten in Draufsicht;
- Fig. 5: das Elektronikmodul mit daran angeordneter Leiterplatte und Drähten in einer Schnittansicht;
- Fig. 6: ein alternatives Elektronikmodul mit daran angeordneter Leiterplatte und Drähten in einer Schnittansicht;
- Fig. 7: ein alternatives Elektronikmodul mit daran angeordneter Leiterplatte und Drähten in einer Schnittansicht.

Die Figuren sind beispielhaft schematisch. Gleiche Bezugszeichen in den Figuren weisen auf gleiche funktionale und/oder strukturelle Merkmale hin.

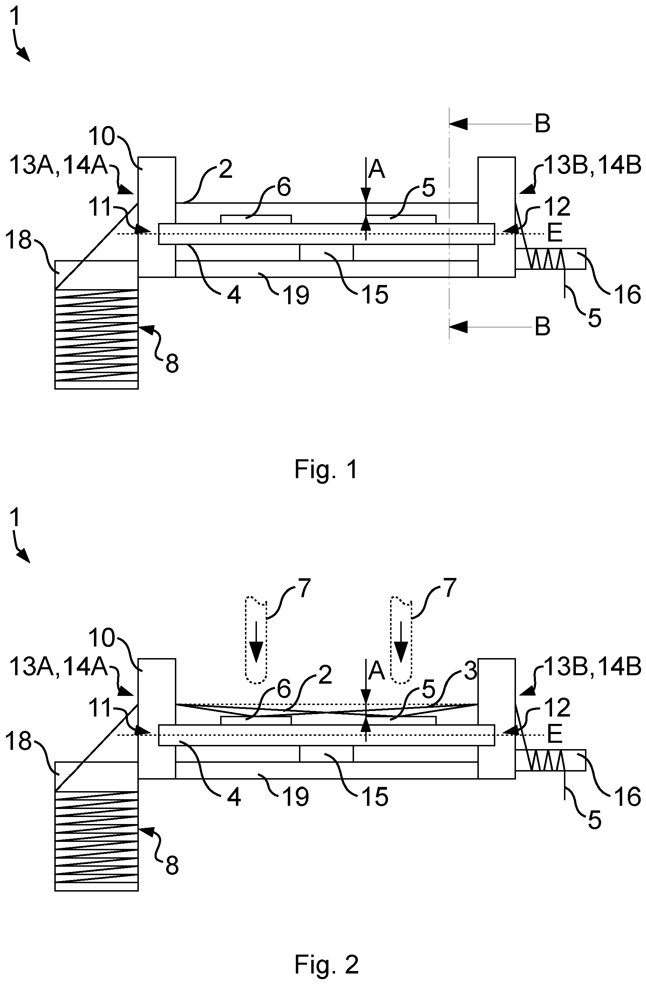

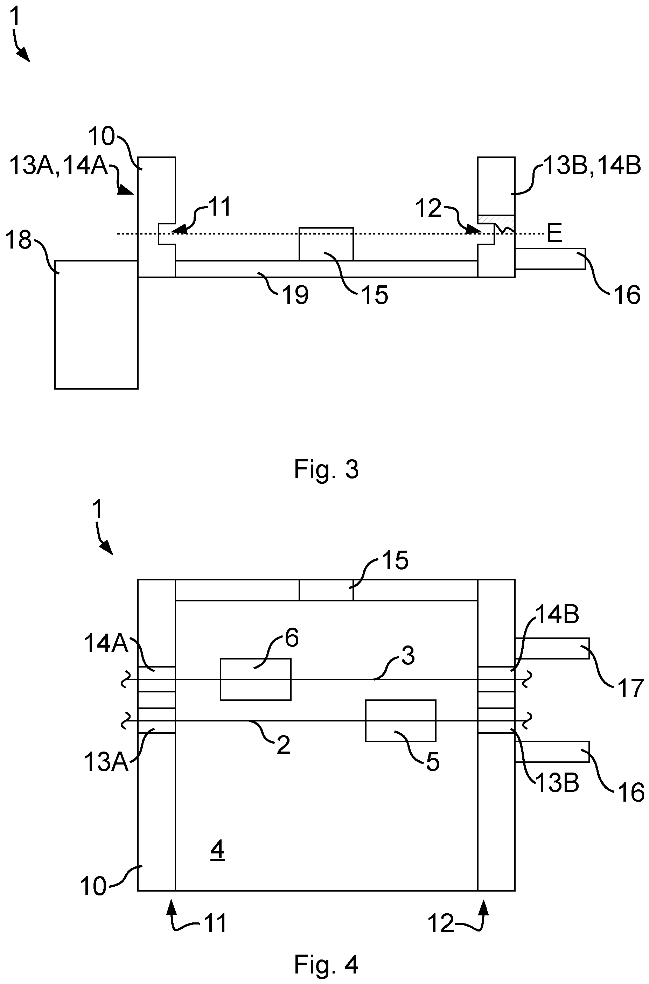

In den Figuren 1 bis 5 ist ein Elektronikmodul 1 mit integrierter Leiterplattenaufnahme 10 dargestellt, wobei in den Figuren 1, 2 sowie 4 und 5 sowohl die Leiterplatte 4 als auch die Drähte 2, 3 dargestellt sind. Die Leiterplatte 4 ist dabei in bzw. an der Leiterplattenaufnahme 10 angeordnet gezeigt. Die Drähte 2,3 sollen, wie insbesondere in Figur 2 sichtbar, mit den Kontaktflächen 5, 6 der Leiterplatte 4 kontaktiert werden.

Bei der in den Figuren dargestellten Variante weist die Leiterplatte 4 zwei Kontaktflächen 5, 6 auf, wobei jeweils ein Draht 2, 3 mit jeweils einer der Kontaktflächen 5, 6 kontaktiert werden soll. Dabei handelt es sich bei den beiden Drähten 2, 3 um die Endabschnitte d.h. die Drahtenden eines einzigen zu der Spule 8 gewickelten und an dem Spulenwicklungskörper 18 angeordneten Drahtes, sodass die Drähte 2, 3 die Drahtenden dieses einen Drahtes darstellen und über den zu der Spule gewickelten Abschnitt miteinander verbunden bzw. einstückig und integral miteinander ausgebildet sind.

Einer der Vorteile des vorgeschlagenen Elektronikmoduls 1 besteht darin, dass die Leiterplatte 4 unabhängig von den Drähten 2, 3 in der Leiterplattenaufnahme 10 angeordnet werden kann und die Drähte 2, 3 wiederum unabhängig von der Leiterplatte 4 in der Leiterplattenaufnahme 10 angeordnet werden können.

Zur Aufnahme der Leiterplatte 4 weist die Leiterplattenaufnahme 10 zwei einander gegenüberliegende Führungsschienen 11, 12 auf, welche an einer Seite über einen Steg oder ein anderes Versteifungselement 19 miteinander verbunden sind. Durch die Führungsschienen 11, 12 wird eine Ebene E definiert in welcher die Leiterplatte 4 in die Führungsschienen 11, 12 und bis in eine Endposition einschiebbar ist, in welcher die Leiterplatte 4 an einem Endanschlag 15 anliegt, so wie es in den Figuren dargestellt ist.

Befindet sich die Leiterplatte 4 in dieser Endposition, sind die Kontaktflächen 5, 6 in einer jeweiligen vorbestimmten Montageposition angeordnet, in welcher die Kontaktflächen 5, 6 zu einem späteren Zeitpunkt mit einem jeweiligen Draht 2, 3 kontaktiert werden können.

Zur Aufnahme der Drähte 2, 3 weist die Leiterplattenaufnahme 10 je Draht ein Paar von Drahtaufnahmen bzw. je zwei Drahtaufnahmen 13A, 13B, 14A, 14B auf, sodass also einem ersten Draht 2 ein erstes Paar von Drahtaufnahmen bzw. zwei Drahtaufnahmen 13A, 13B und einem zweiten Draht 3 ein zweites Paar von Drahtaufnahmen bzw. zwei Drahtaufnahmen 14A, 14B zugeordnet sind. Die zwei Drahtaufnahmen 13A, 13B bzw. 14A, 14B eines Paares sind dabei einander gegenüberliegend an der Leiterplattenaufnahme 10 angeordnet, sodass also ein von Drahtaufnahme 13A bzw. 14A zu Drahtaufnahme 13B bzw. 14B führendes Draht im Wesentlichen parallel der Ebene E verläuft.

Die Drahtaufnahmen 13A, 13B, 14A, 14B sind dabei generell ausgebildet, den jeweiligen Draht 2, 3 in einem vorbestimmten Abstand A von der Montageposition d.h. in einem vorbestimmten Abstand A von der jeweiligen Kontaktfläche 5, 6 zu halten. Da der Abstand der Kontaktflächen 5, 6 zu der Ebene E bekannt ist, kann der Abstand A auch allgemein als der Abstand zwischen den Drähten 2, 3 und der Ebene E definiert werden, wobei dann die Dicken der Leiterplatte 4 und der die Kontaktflächen 5, 6 bereitstellenden Kontaktpads berücksichtigt werden müssen.

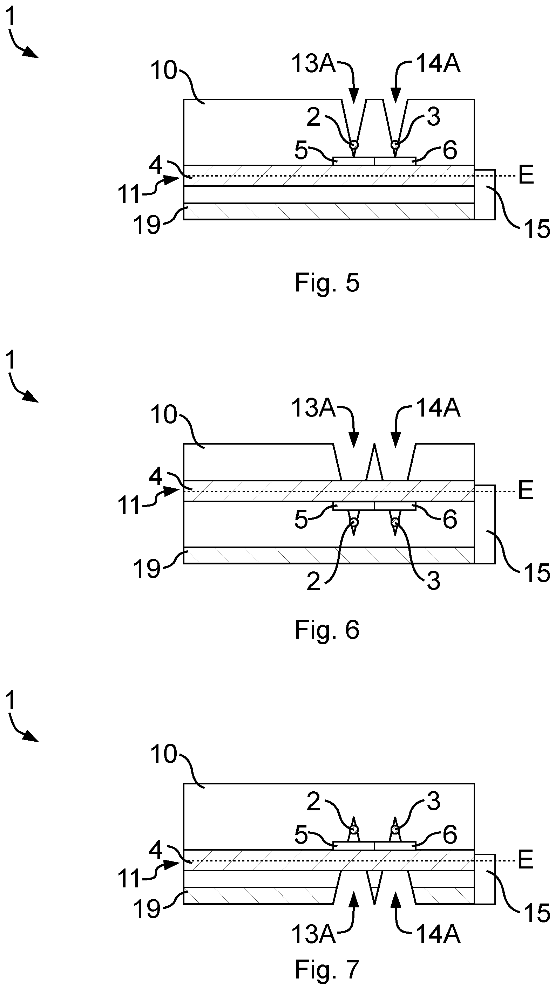

Um die Drähte 2, 3 unabhängig von der Leiterplatte 4 und in einfacherweise positionieren zu können, sind die Drahtaufnahmen 13A, 13B, 14A, 14B als sich v-förmig verjüngende Nuten ausgebildet, wie es insbesondere in Figur 5 sichtbar ist. Durch die dargestellte Form der Drahtaufnahmen 13A, 13B, 14A, 14B können die Drähte 2, 3 von der geöffneten Seite der Nut einfach eingeführt und zu der sich verjüngenden Seite hin zentriert werden.

Ist keine Fixierung durch die Drahtaufnahmen 13A, 13B, 14A, 14B selbst vorgesehen, kann das Elektronikmodul 1 ein Fixierelement oder wie dargestellt je Draht 2, 3 ein Fixierelement 16, 17 aufweisen, um welches die Drähte 2, 3 bzw. deren freie Enden 5 gewickelt und dadurch fixiert werden können. Alternativ könnte auch ein einziges Fixierelement für beide Drähte 2, 3 vorgesehen sein, welches beispielsweise zwischen den Drahtaufnahmen 13B, 14B angeordnet sein könnte.

Unabhängig davon, ob zunächst die Leiterplatte 4 in der Leiterplattenaufnahme 10 oder ob zunächst die Drähte 2, 3 in der Leiterplattenaufnahme 10 angeordnet wurden, kann anschließend das eigentliche Kontaktieren der Drähte 2, 3 mit der jeweiligen Kontaktfläche 5, 6 erfolgen.

Hierfür wird vorzugsweise ein als Stempel ausgebildetes und in Figur 2 dargestelltes Montagewerkzeug 7 verwendet, welches die Drähte 2, 3 jeweils einzeln gegen die jeweils zugehörige Kontaktfläche 5, 6 presst und vorzugsweise im Lötverfahren und weiter vorzugsweise Bügellötverfahren mit der Kontaktfläche 5, 6 verlötet, sodass die Drähte 2, 3 mit der jeweiligen Kontaktfläche 5, 6 dauerhaft elektrisch kontaktiert sind.

Die Drahtaufnahmen 13A, 13B, 14A, 14B müssen sich nicht zwingend wie in Figur 5 dargestellt von einer gemeinsamen Seite in Richtung der Ebene E erstrecken, ohne diese zu schneiden.

Weitere Varianten sind auch in den Figuren 6 und 7 dargestellt, wobei zusätzliche Weiterbildungen möglich sind. Dabei stellen die in den Figuren 5 bis 7 dargestellten Ansichten Schnitte durch das Elektronikmodul 1 gemäß dem in Figur 1 eingezeichneten Schnittverlauf B-B dar.

Beispielsweise können sich die Drahtaufnahmen 13A, 13B, 14A, 14B von einer freien d.h. nicht durch das Versteifungselement 19 verdeckten Seite der Leiterplattenaufnahme 10 bis über die Ebene E hinaus hinter die Ebene E erstrecken, wie es in Figur 6 gezeigt ist.

Alternativ können sich die Drahtaufnahmen 13A, 13B, 14A, 14B von der durch das Versteifungselement 19 verdeckten Seite der Leiterplattenaufnahme 10, so wie in Figur 7, bis über die Ebene E hinaus hinter die Ebene E erstrecken, wobei in dem Versteifungselement 19 entsprechende Ausnehmungen vorgesehen sind, durch welche die Drähte 2, 3 sowie gegebenenfalls das Montagewerkzeug 7 geführt werden können.

Weiter können sich die Drahtaufnahmen 13A, 13B, 14A, 14B eines Paares oder unterschiedlicher Paare von Drahtaufnahmen 13A, 13B, 14A, 14B auch von verschiedenen Seiten zu der Ebene E oder über die Ebene E hinaus erstrecken, was jedoch nicht dargestellt ist.

## Patentansprüche

1. Elektronikmodul (1) mit integrierter Leiterplattenaufnahme (10) zur Kontaktierung zumindest eines Drahtes (2, 3) mit einer in der Leiterplattenaufnahme (10) anordenbaren Leiterplatte (4),
wobei die Leiterplattenaufnahme (10) zumindest ein Führungselement (11, 12) aufweist, welches ausgebildet ist, die in der Leiterplattenaufnahme anordenbare Leiterplatte (4) in eine vorbestimmte Endposition zu führen, in welcher die Leiterplatte (4) in einer vorbestimmten Ebene (E) angeordnet ist und sich auf der Leiterplatte (4) vorgesehene Kontaktflächen (5, 6) in einer vorbestimmten Montageposition befinden,
wobei die Leiterplattenaufnahme (10) je mit der Leiterplatte (4) zu kontaktierenden Draht (2, 3) zwei Drahtaufnahmen (13A, 13B, 14A, 14B) aufweist, welche einander an der Leiterplattenaufnahme (10) gegenüberliegen und ausgebildet sind, einen zwischen den zwei Drahtaufnahmen (13A, 13B, 14A, 14B) geradlinig und frei verlaufenden Draht (2, 3) aufzunehmen,
wobei die zwei Drahtaufnahmen (13A, 13B, 14A, 14B) ferner ausgebildet sind, zumindest einen Drahtabschnitt des geradlinig zwischen den zwei Drahtaufnahmen (13A, 13B, 14A, 14B) verlaufenden Drahtes (2, 3) in einem vorbestimmten Abstand (A) zu der Montageposition verlaufend zu halten, sodass der Draht (2, 3) mit dem Drahtabschnitt von einem Montagewerkzeug (7) gegen die jeweilige Kontaktfläche (5, 6) pressbar und mit der Kontaktfläche (5, 6) verbindbar ist.

2. Elektronikmodul nach Anspruch 1,
wobei die Leiterplattenaufnahme (10) zwei einander gegenüberliegende Führungsschienen (11, 12) als Führungselemente (11, 12) aufweist, zwischen welche die Leiterplatte (4) in der Ebene (E) einschiebbar ist.

3. Elektronikmodul nach Anspruch 2,
wobei jeweils eine Drahtaufnahme (13A, 13B, 14A, 14B) der zwei Drahtaufnahmen (13A, 13B, 14A, 14B) jeweils einer Führungsschiene (11, 12) der zwei Führungsschienen (11, 12) zugeordnet ist.

4. Elektronikmodul nach Anspruch 1,
wobei die Leiterplattenaufnahme (10) zumindest einen sich orthogonal zu der Ebene (E) erstreckenden Führungszapfen als Führungselement aufweist, entlang welchem die Leiterplatte (4) in die Ebene (E) schiebbar ist.

5. Elektronikmodul nach einem der vorhergehenden Ansprüche,
wobei die Leiterplattenaufnahme (10) zumindest einen sich orthogonal zu der Ebene (E) erstreckenden und die Endposition bestimmenden Endanschlag (15) aufweist, gegen welchen die Leiterplatte (4) schiebbar ist.

6. Elektronikmodul nach einem der vorhergehenden Ansprüche,
wobei zumindest ein Teil der Drahtaufnahmen (13A, 13B, 14A, 14B) und insbesondere alle Drahtaufnahmen (13A, 13B, 14A, 14B) jeweils als sich verjüngende Nuten ausgebildet sind, in welche der jeweilige Draht (2, 3) zur Zentrierung und Positionierung des Drahtes (2, 3) von einer geöffneten Seite der Nuten einführbar ist.

7. Elektronikmodul nach einem der vorhergehenden Ansprüche,
wobei sich ein Teil der Drahtaufnahmen (13A, 13B, 14A, 14B) und insbesondere alle Drahtaufnahmen (13A, 13B, 14A, 14B) von einer von der Ebene (E) abgewandten Seite der Leiterplattenaufnahme (10) bis an die Ebene (E) erstrecken ohne die Ebene (E) zu schneiden, sodass der zwischen den Drahtaufnahmen (13A, 13B, 14A, 14B) verlaufende Draht (2, 3) an einer ersten Seite der Ebene (E) angeordnet ist,
und/oder wobei sich ein Teil der Drahtaufnahmen (13A, 13B, 14A, 14B) und insbesondere alle Drahtaufnahmen (13A, 13B, 14A, 14B) von einer von der Ebene (E) abgewandten Seite der Leiterplattenaufnahme (10) bis über die Ebene (E) hinaus erstrecken und die Ebene (E) schneiden, sodass der zwischen den Drahtaufnahmen (13A, 13B, 14A, 14B) verlaufende Draht (2, 3) an einer zweiten Seite der Ebene (E) angeordnet ist.

8. Elektronikmodul nach einem der vorhergehenden Ansprüche,
wobei die Leiterplattenaufnahme (10) insbesondere je mit der Leiterplatte (4) zu kontaktierenden Draht (2, 3) ein insbesondere als Wickelzapfen (16, 17) ausgebildetes Fixierelement (16, 17) aufweist, an welchem ein insbesondere freies Ende (5) des geradlinig zwischen den zwei Drahtaufnahmen (13A, 13B, 14A, 14B) verlaufenden Drahtes (2, 3) fixierbar ist.

9. Elektronikmodul nach einem der vorhergehenden Ansprüche,
wobei der vorbestimmte Abstand (A) des Drahtes (2, 3) zu der Montageposition kleiner 5 mm, insbesondere kleiner 1 mm und weiter insbesondere gleich oder kleiner 0,5 mm ist.

10. Elektronikmodul nach einem der vorhergehenden Ansprüche,
ferner aufweisend einen Spulenwicklungskörper (18) um welchem eine aus dem zumindest einem Draht (2, 3) gewickelte Spule (8) anordenbar oder wickelbar ist.

11. Verfahren zur Kontaktierung zumindest eines Drahtes (2, 3) mit einer in der Leiterplattenaufnahme (10) des Elektronikmoduls (1) gemäß einem der vorhergehenden Ansprüche anordenbaren Leiterplatte (4) umfassend die Schritte
a. Anordnen der Leiterplatte (4) in der Leiterplattenaufnahme (10), sodass sich die je Draht (2, 3) auf der Leiterplatte (4) vorgesehene Kontaktfläche (5, 6) in der Montageposition befindet;
b. Anordnen des zumindest einen Drahts (2, 3) in den jeweiligen Drahtaufnahmen (13A, 13B, 14A, 14B), sodass der Draht (2, 3) geradlinig zwischen den zwei Drahtaufnahmen (13A, 13B, 14A, 14B) verläuft und den vorbestimmten Abstand (A) zu der Montageposition aufweist;
c. Kontaktieren des zumindest einen Drahts (2, 3) mit der jeweiligen Kontaktfläche (5, 6) durch Pressen des Drahtes (2, 3) gegen die Kontaktfläche (5, 6) und elektrische Kontaktierung mit der Kontaktfläche (5, 6), insbesondere durch Löten und weiter insbesondere im Bügellötverfahren;
**dadurch gekennzeichnet, dass** die Schritte sowohl in der Reihenfolge a, b, c als auch b, a, c durchführbar sind.

## Claims

1. An electronic module (1) with an integrated circuit board holder (10) for contacting at least one wire (2, 3) with a circuit board (4) which can be arranged in the circuit board holder (10),
wherein the circuit board holder (10) has at least one guide element (11, 12) which is formed to guide the circuit board (4) which can be arranged in the circuit board holder to a predetermined end position in which the circuit board (4) is arranged in a predetermined plane (E) and contact surfaces (5, 6) provided on the circuit board (4) are in a predetermined mounting position,
wherein the circuit board holder (10) has two wire holders (13A, 13B, 14A, 14B) per wire (2, 3) to be contacted with the circuit board (4), which are opposite to one another on the circuit board holder (10) and are formed to hold a wire (2, 3) running straight and freely between the two wire holders (13A, 13B, 14A, 14B),
wherein the two wire holders (13A, 13B, 14A, 14B) are further formed to keep at least one wire section of the wire (2, 3) running straight between the two wire holders (13A, 13B, 14A, 14B) at a predetermined distance (A) to the mounting position so that the wire (2, 3) can be pressed against the respective contact surface (5, 6) with the wire section by a pressing tool (7) and can be connected with the contact surface (5, 6).

2. The electronic module according to claim 1,
wherein the circuit board holder (10) has two guide rails (11, 12) opposite to one another as guide elements (11, 12) between which the circuit board (4) can be inserted in the plate (E).

3. The electronic module according to claim 2,
wherein a respective wire holder (13A, 13B, 14A, 14B) of the two wire holders (13A, 13B, 14A, 14B) is respectively assigned to a guide rail (11, 12) of the two guide rails (11, 12).

4. The electronic module according to claim 1,
wherein the circuit board holder (10) has at least one guide pin as a guide element extending orthogonally to the plane (E) and along which the circuit board (4) can be slid into the plane (E).

5. The electronic module according to any one of the preceding claims,
wherein the circuit board holder (10) has at least one end stop (15) extending orthogonally to the plane (E) and determining the end position, against which the circuit board (4) can be slid.

6. The electronic module according to any one of the preceding claims,
wherein at least a part of the wire holders (13A, 13B, 14A, 14B) and in particular all wire holders (13A, 13B, 14A, 14B) are respectively formed as tapering grooves into which the respective wire (2, 3) can be inserted from an opened side of the grooves for centring and positioning the wire (2, 3).

7. The electronic module according to any one of the preceding claims,
wherein a part of the wire holders (13A, 13B, 14A, 14B) and in particular all wire holders (13A, 13B, 14A, 14B) extend from a side of the circuit board holder (10) facing away from the plane (E) up to the plane (E) without intersecting the plane (E) so that the wire (2, 3) running between the wire holders (13A, 13B, 14A, 14B) is arranged on a first side of the plane (E),
and/or wherein a part of the wire holders (13A, 13B, 14A, 14B) and in particular all wire holders (13A, 13B, 14A, 14B) extend from a side of the circuit board holder (10) facing away from the plane (E) beyond the plane (E) and intersect the plane (E) so that the wire (2, 3) running between the wire holders (13A, 13B, 14A, 14B) is arranged on a second side of the plane (E).

8. The electronic module according to any one of the preceding claims,
wherein the circuit board holder (10) in particular has a fixation element (16, 17) in particular formed as a winding pin (16, 17) per wire (2, 3) to be contacted with the circuit board (4), on which an in particular free end (5) of the wire (2, 3) running straight between the two wire holders (13A, 13B, 14A, 14B) can be fixed.

9. The electronic module according to any one of the preceding claims,
wherein the predetermined distance (A) of the wire (2, 3) to the mounting position is less than 5 mm, in particular less than 1 mm and further in particular equal to or less than 0.5 mm.

10. The electronic module according to any one of the preceding claims,
further having a coil winding body (18) about which a coil (8) wound from the at least one wire (2, 3) can be arranged or wound.

11. A method for contacting at least one wire (2, 3) with a circuit board (4) which can be arranged in the circuit board holder (10) of the electronic module (1) according to any one of the preceding claims, comprising the steps of
a. arranging the circuit board (4) in the circuit board holder (10) so that the contact surface (5, 6) provided on the circuit board (4) per wire (2, 3) is in the mounting position;
b. arranging the at least one wire (2, 3) in the respective wire holders (13A, 13B, 14A, 14B) so that the wire (2, 3) runs straight between the two wire holders (13A, 13B, 14A, 14B) and has the predetermined distance (A) to the mounting position;
c. contacting the at least one wire (2, 3) with the respective contact surface (5, 6) by pressing the wire (2, 3) against the contact surface (5, 6) and electrical contacting with the contact surface (5, 6), in particular through soldering and further in particular with the hot bar soldering method;
**characterised in that** the steps can be performed both in the order a, b, c and b, a, c.

## Revendications

1. Module électronique (1), comprenant un logement de carte de circuits imprimés intégré (10) pour la mise en contact d'au moins un fil (2, 3) avec une carte de circuits imprimés (4) pouvant être disposée dans le logement de carte de circuits imprimés (10),
dans lequel le logement de carte de circuits imprimés (10) présente au moins un élément de guidage (11, 12) qui est réalisé pour guider la carte de circuits imprimés (4) pouvant être disposée dans le logement de carte de circuits imprimés vers une position d'extrémité prédéterminée dans laquelle la carte de circuits imprimés (4) est disposée dans un plan prédéterminé (E), et des surfaces de contact (5, 6) prévues sur la carte de circuits imprimés (4) se trouvent dans une position de montage prédéterminée,
dans lequel le logement de carte de circuits imprimés (10) présente pour chaque fil (2, 3) à mettre en contact avec la carte de circuits imprimés (4) deux logements de fil (13A, 13B, 14A, 14B) qui sont opposés l'un à l'autre au niveau du logement de carte de circuits imprimés (10) et sont réalisés pour recevoir un fil (2, 3) s'étendant en ligne droite et librement entre les deux logements de fil (13A, 13B, 14A, 14B),
dans lequel les deux logements de fil (13A, 13B, 14A, 14B) sont réalisés en outre pour maintenir au moins un tronçon de fil du fil (2, 3) s'étendant en ligne droite entre les deux logements de fil (13A, 13B, 14A, 14B) à une distance prédéterminée (A) par rapport à la position de montage de sorte que le fil (2, 3) peut être comprimé avec le tronçon de fil par un outil de montage (7) contre la surface de contact (5, 6) respective et peut être relié à la surface de contact (5, 6).

2. Module électronique selon la revendication 1,
dans lequel le logement de carte de circuits imprimés (10) présente deux rails de guidage (11, 12) opposés l'un à l'autre en tant qu'éléments de guidage (11, 12) entre lesquels la carte de circuits imprimés (4) peut être insérée dans le plan (E).

3. Module électronique selon la revendication 2,
dans lequel respectivement un logement de fil (13A, 13B, 14A, 14B) des deux logements de fil (13A, 13B, 14A, 14B) est associé respectivement à un rail de guidage (11, 12) des deux rails de guidage (11, 12).

4. Module électronique selon la revendication 1,
dans lequel le logement de carte de circuits imprimés (10) présente au moins un tenon de guidage s'étendant orthogonalement au plan (E) en tant qu'élément de guidage, le long duquel la carte de circuits imprimés (4) peut être poussée dans le plan (E).

5. Module électronique selon l'une quelconque des revendications précédentes,
dans lequel le logement de carte de circuits imprimés (10) présente au moins une butée d'extrémité (15) s'étendant orthogonalement au plan (E) et déterminant la position d'extrémité contre laquelle la carte de circuits imprimés (4) peut être poussée.

6. Module électronique selon l'une quelconque des revendications précédentes,
dans lequel au moins une partie des logements de fil (13A, 13B, 14A, 14B), et en particulier tous les logements de fil (13A, 13B, 14A, 14B), sont respectivement réalisés sous la forme de rainures effilées dans lesquelles le fil (2, 3) respectif peut être introduit à partir d'un côté ouvert des rainures pour le centrage et le positionnement du fil (2, 3).

7. Module électronique selon l'une quelconque des revendications précédentes,
dans lequel une partie des logements de fil (13A, 13B, 14A, 14B), et en particulier tous les logements de fil (13A, 13B, 14A, 14B), s'étendent d'un côté, détourné du plan (E), du logement de carte de circuits imprimés (10) jusqu'au plan (E) sans couper le plan (E) de sorte que le fil (2, 3) s'étendant entre les logements de fil (13A, 13B, 14A, 14B) est disposé sur un premier côté du plan (E),
et/ou dans lequel une partie des logements de fil (13A, 13B, 14A, 14B), et en particulier tous les logements de fil (13A, 13B, 14A, 14B), s'étendent à partir d'un côté, détourné du plan (E), du logement de carte de circuits imprimés (10) jusqu'au-delà du plan (E) et coupent le plan (E) de sorte que le fil (2, 3) s'étendant entre les logements de fil (13A, 13B, 14A, 14B) est disposé sur un deuxième côté du plan (E).

8. Module électronique selon l'une quelconque des revendications précédentes,
dans lequel le logement de carte de circuits imprimés (10), en particulier pour chaque fil (2, 3) à mettre en contact avec la carte de circuits imprimés, présente un élément de fixation (16, 17) réalisé en particulier sous forme de tenon d'enroulement (16, 17) et auquel une extrémité (5) en particulier libre du fil (2, 3) s'étendant en ligne droite entre les deux logements de fil (13A, 13B, 14A, 14B) peut être fixée.

9. Module électronique selon l'une quelconque des revendications précédentes,
dans lequel la distance prédéterminée (A) du fil (2, 3) par rapport à la position de montage est inférieure à 5 mm, en particulier inférieure à 1 mm, et en outre en particulier égale ou inférieure à 0,5 mm.

10. Module électronique selon l'une quelconque des revendications précédentes,
présentant en outre un corps d'enroulement de bobine (18) autour duquel une bobine (8) enroulée à partir dudit au moins un fil (2, 3) peut être disposée ou enroulée.

11. Procédé permettant de mettre en contact au moins un fil (2, 3) avec une carte de circuits imprimés (4) disposée dans le logement de carte de circuits imprimés (10) du module électronique (1) selon l'une quelconque des revendications précédentes, comprenant les étapes consistant à
a. disposer la carte de circuits imprimés (4) dans le logement de carte de circuits imprimés (10) de sorte que la surface de contact (5, 6) prévue pour chaque fil (2, 3) sur la carte de circuits imprimés (4) se trouve dans la position de montage ;
b. disposer ledit au moins un fil (2, 3) dans les logements de fil (13A, 13B, 14A, 14B) respectifs de sorte que le fil (2, 3) s'étend en ligne droite entre les deux logements de fil (13A, 13B, 14A, 14B) et présente la distance prédéterminée (A) par rapport à la position de montage ;
c. mettre en contact ledit au moins un fil (2, 3) avec la surface de contact (5, 6) respective par compression du fil (2, 3) contre la surface de contact (5, 6) et mise en contact électrique avec la surface de contact (5, 6), en particulier par brasage et similaire, et en outre en particulier par brasage à la barre chaude ;
**caractérisé en ce que** les étapes peuvent être exécutées aussi bien dans l'ordre a, b, c que b, a, c.
